# EUROPEAN PATENT APPLICATION

(11) **EP 2 101 372 A1**
(43) Date of publication of application: **16.09.2009**
(21) Application number: 09003561.9
(22) Date of filing: 11.03.2009
(51) Int. Cl.: H01Q 1/52, H01Q 9/04, H05K 9/00

(54) **Antenna apparatus**

(30) Priority: 11.03.2008 JP 2008061049
(71) Applicant: Mitsumi Electric Co., Ltd., Tama-shi, Tokyo 206-8567 (JP)
(72) Inventor: Saito, Kazunari, Katagami-shi Akita (JP); Suzuki, Hiroshi, Katagami-shi Akita (JP)
(74) Representative: Grünecker, Kinkeldey, Stockmair & Schwanhäusser Anwaltssozietät

(57) **Abstract**

An antenna apparatus is disclosed. A circuit is provided on the board and configured to amplify a signal received by an antenna element. A conductive pattern is provided on the board. A coaxial cable comprises a core wire connected to the circuit and an outer conductor. A shielding cover is disposed on the board and covering the circuit. A solder electrically connects the outer conductor with the conductive pattern and electrically connects a part of the shielding cover with the conductive pattern.

## Description

### BACKGROUND

The present invention relates to an antenna apparatus and, more particularly, an antenna apparatus used for receiving a radio wave from a GPS (Global Positioning System), a satellite radio, and the like.

### [Background Art]

A compact antenna apparatus into which a patch antenna and circuitry for eliminating noise, performing amplification, and the like, are integrated is developed as an antenna apparatus for a vehicle-mounted GPS system proliferated as a positioning system and an antenna apparatus used for a satellite radio, and the like, of a vehicle-mounted type or a house installation type commercialized in US (see; for instance, Patent Documents 1,2).

Such an antenna apparatus is often provided with a shielding cover for blocking a disturbing wave from the outside by covering circuitry. Drive power is supplied to circuitry in the antenna apparatus by way of a core wire of a coaxial cable, and a signal amplified by the circuitry is concurrently output by way of the core wire. However, in order to block a disturbing wave, the antenna apparatus is often configured by connecting an outer conductor of the coaxial cable to the shielding cover, to thus supply a GND potential to the shielding cover.

For instance, in connection with the antenna apparatus described in Patent Document 1, there is proposed a coaxial cable connection structure for an antenna apparatus in which a tongue horizontally extends from a side wall of a shielding cover; in which an outer conductor of a coaxial cable is fitted to an edge, to thus mechanically fix the conductor; and in which an earth terminal to be connected to the coaxial cable is provided on the shielding cover.

As shown in Fig. 7, in an antenna apparatus 100 described in Patent Document 2, an substantially-box-shaped metal shielding cover 104 covers an unillustrated circuit fabricated on one side of a circuit board 103 affixed, on the other side thereof, with an antenna element 102 having a patch-type receiving surface 101 for receiving a radio wave, thereby blocking a disturbing wave from the outside. A coaxial cable 105, which supplies drive power to the circuit by way of a core wire 105a and which outputs a signal received by the antenna element 102 and amplified by the circuit, is inserted into the shielding cover 104.

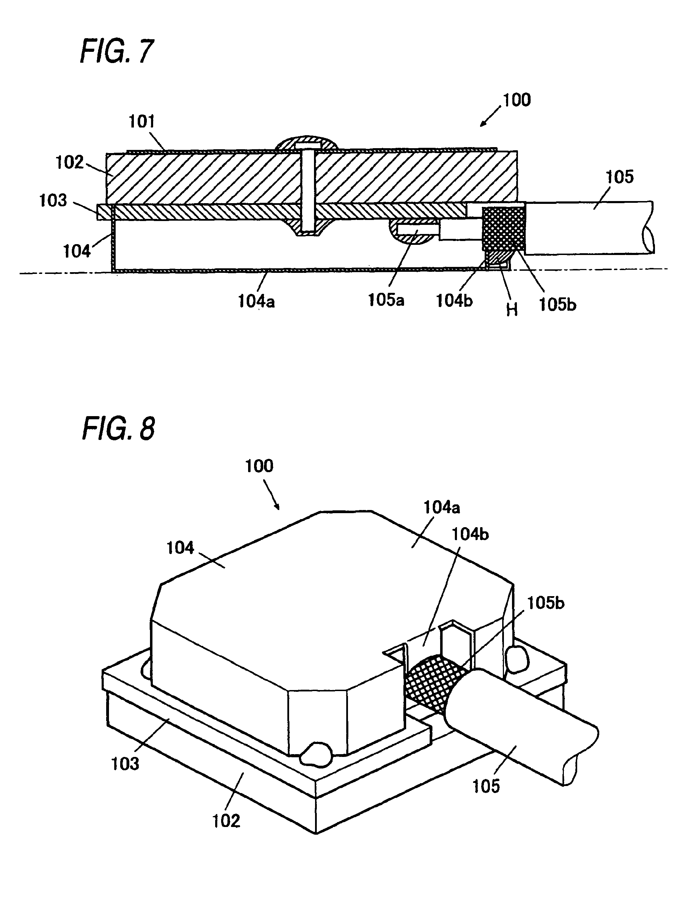

As shown in Fig. 8 that illustrates the antenna apparatus 100 shown in Fig. 7 upside down, a tongue 104b provided on the shielding cover 104 is connected and soldered to an outer conductor 105b of the coaxial cable 105 by solder H in the antenna apparatus 100 (see Fig. 7), whereby a GND potential is fed to the shielding cover 104 by way of the tongue 104b. The shielding cover 104 is connected to a GND terminal of the circuit, and the circuit is also grounded by way of the shielding cover 104.

A receiving surface 101 of the antenna element 102 is depicted in Fig. 7 as being thicker than an actual receiving surface. Further, the solder H, or the like, used for connecting the tongue 104b of the shielding cover 104 with the outer conductor 105b of the coaxial cable 105 is omitted from Fig. 8.
[Patent Document 1] Japanese Patent Publication No. 9-205305 A
[Patent Document 2] Japanese Patent Publication No. 11-074671 A

Incidentally, a PND (Portable Navigation Device) embodied by equipping a compact electronic device with a navigation function has become widespread. For instance, when an antenna apparatus, such as that mentioned above, is incorporated into such a PND, downsizing and height reduction of the antenna apparatus are demanded. Further, a diameter reduction of the coaxial cable used in the antenna apparatus is demanded.

For instance, in the antenna apparatus described in Patent Document 1, an earth terminal extended out of the shielding cover is downsized in agreement with the coaxial cable whose diameter is reduced. However, operation for fitting and connecting the outer conductor of the coaxial cable to the earth terminal becomes very delicate. Further, the coaxial cable is attached to the earth terminal after the shielding cover is fixed to the circuit board, and a core wire of the coaxial cable is soldered to the circuit. Hence, an opening of the shielding cover used for inserting a leading end of a soldering iron occupies a large area relative to the shielding cover to be downsized, so that performance of the shielding cover for blocking a disturbing wave is deteriorated.

The antenna apparatus 100 described in Patent Document 2 has a structure in which the tongue 104b is soldered while the tongue 104b shown in Figs. 7 and 8 presses the coaxial cable 105 against the circuit board 103. Hence, a height reduction of the shielding cover 104 is hindered by an amount corresponding to the space where the tongue 104b is to be positioned, thereby posing a problem of difficulty being encountered in making an attempt to reduce the size and height of the antenna apparatus.

### SUMMARY

It is therefore one advantageous aspect of the present invention to provide an antenna apparatus having a soldered structure that enables a height reduction of a shielding cover and making of an attempt to reduce the size and height of the device.

According to one aspect of the invention, there is provided an antenna apparatus comprising:
According to one aspect of the invention, there is provided an antenna apparatus, comprising:
   an antenna element;
   a board;
   a circuit, provided on the board and configured to amplify a signal received by the antenna element;
   a conductive pattern, provided on the board;
   a coaxial cable comprising a core wire connected to the circuit and an outer conductor;
   a shielding cover disposed on the board and covering the circuit; and
   a solder electrically connecting the outer conductor with the conductive pattern and electrically connecting a part of the shielding cover with the conductive pattern.

When the GND potential is fed from the outer conductor of the coaxial cable to the conductive pattern, the GND potential is supplied to the shielding cover by way of the connection piece, whereupon the shielding cover is grounded. At that time, the shielding cover is provided with a structure in which the outer conductor of the coaxial cable and the connection piece of the shielding cover are connected to the conductive pattern provided on the circuit board by soldering rather than the structure in which the tongue 104b, such as that provided in the antenna apparatus 100 described in connection with Patent Document 2, is provided. Therefore, the thickness of the shielding cover can be reduced to about an outer diameter of the coaxial cable inserted into the shielding cover or an outer diameter of the outer conductor of the coaxial cable.

Using a cable having a small diameter as the coaxial cable to be inserted enables making of an attempt to reduce the size and height of the shielding cover to about the outer diameter of the coaxial cable having a reduced diameter, whereby an attempt can be made to reduce the size and height of the entire antenna apparatus. Therefore, the antenna apparatus can be sufficiently miniaturized to the extent that the antenna apparatus can be incorporated in the previously-described PND, and the like.

Further, the coaxial cable is fastened to the circuit board by soldering the outer conductor of the coaxial cable to the conductive pattern provided on the circuit board. Hence, a special coaxial cable connection structure, such as that required for the antenna apparatus described in connection with Patent Document 1, is not required; operation for connecting the coaxial cable to the circuit board is facilitated; and a connection can be established reliably.

Moreover, the shielding cover is attached to the circuit board after the core wire of the coaxial cable has been connected to the input section of the circuit by soldering. Hence, there is obviated a necessity of forming in the shielding cover a large opening for soldering the core wire of the coaxial cable to the input section as in the antenna apparatus described in connection with Patent Document 1, so that deterioration in the performance of the shielding cover for blocking a disturbing wave can be prevented.

The antenna element may be configured such that: the conductive pattern is electrically grounded.

The invention defined enables enhancement of grounding efficiency of the shielding cover and grounding efficiency of the GND pattern of the circuit because a GND potential is supplied to the GND pattern of the circuit as well as to the shielding cover by way of the connection piece as a result of the GND potential being supplied to the conductive pattern from the outer conductor of the coaxial cable.

The antenna element may be configured such that: the part of the shielding cover serves as a side wall of the shielding cover.

The invention enables effective blocking of a disturbing wave reaching the circuit from the outside even at an attached portion of the coaxial cable because the connection piece of the shielding cover doubles as the side wall of the shielding cover.

The antenna element may be configured such that: the part of the shielding cover is adjacent to the coaxial cable in a direction which is parallel to the board.

The connection piece of the shielding cover is soldered to the conductive pattern at a position beside the conductive pattern to which the outer conductor of the coaxial cable is soldered, whereby the connection piece of the shielding cover can be soldered to the conductive pattern by causing a soldering iron to approach the pattern from a widely-open side where the base surface of the shielding cover, and the like, is not present. Even when the shielding cover is reduced in terms of a size and a height, soldering can be performed sufficiently-readily and reliably. Therefore, advantages of the respective inventions are yielded more effectively.

The antenna element may be configured such that: the shielding cover is formed with an opening through which the coaxial cable is inserted into inside of the shielding cover, and the part of the shielding cover defines a part of the opening.

The antenna element may be configured such that: at least a part of the conductive pattern is disposed outside of the shielding cover, the shielding cover comprises a plate having a first edge and a second edge intersecting the first edge, and the first edge and the second edge face the part of the conductive pattern, the part of the shielding cover is extended from the first edge towards the board.

The inventions enable easy formation of an opening and a connection piece by cutting one corner of the base surface of shielding cover into an substantially-rectangular shape; causing a portion of an edge of the thus-cut area to extend toward the circuit board, to thus create a connection piece; and forming an opening, into which a coaxial cable is to be inserted, in the other portion of the cut area.

Therefore, there is obviated a necessity for providing a special coaxial cable connection structure as required in the antenna apparatus described in connection with Patent Document 1. Further, the essential requirement is to attach a shielding cover to a circuit board to which the coaxial cable is connected and to solder the connection piece to the conductive pattern. Hence, operation for manufacturing an antenna apparatus becomes very easy.

The antenna element may be configured such that: the opening is disposed between the second edge and the part of the shielding cover.

The connection piece of the shielding cover is formed at a location on one edge of the cut area which is separated from the other edge. As a result, the connection piece of the shielding cover can be soldered to the conductive pattern by causing the soldering iron to approach the pattern from a widely-open side where the base surface of the shielding cover, or the like, is not present, and soldering can be performed sufficiently readily, reliably even when the size and height of the shielding cover are reduced. Therefore, the advantages of the respective inventions are yielded more effectively.

The antenna element may be configured such that: at least a part of the conductive pattern is disposed outside of the shielding cover.

The invention enables easy, reliable soldering of the conductive pattern to the connection piece by providing the conductive pattern outside of the connection piece of the shielding cover on the circuit board.

The antenna element may be configured such that: an edge of the part of the conductive pattern opposes the part of the shielding cover with a gap in a direction which is parallel to the board.

The invention enables prevention of raising of the shielding cover from the circuit board, which would otherwise be caused by the solder solidified on the conductive pattern in a raised manner when the outer conductor of the coaxial cable is soldered to the conductive pattern, by providing the conductive pattern such that the edge of the conductive pattern facing the connection piece is located outside of the connection piece on the circuit board. The shielding cover can be attached while parallelism between the base surface of the shielding cover and the circuit surface of the circuit board is assured.

### BRIEF DESCRIPTION OF THE DRAWINGS

Fig. 1A is a schematic cross-section view showing an antenna apparatus according to an embodiment of the present invention.
Fig. 1 B is a perspective view of the antenna apparatus.
Fig. 2A is a bottom view showing a situation that a shielding cover of the antenna apparatus shown in Figs. 1A and 1 B is removed and before an outer conductor of a coaxial cable is soldered.
Fig. 2B is a perspective view of the shielding cover shown in Fig. 2A.
Fig. 3 is an enlarged bottom view showing a situation that a core wire and the outer conductor of the coaxial cable are soldered under the situation shown in Fig. 2A.
Fig. 4 is a cross view along a line X-X shown in Fig. 3.
Fig. 5 is a perspective view of a part of the antenna apparatus under a situation that the shielding cover is assembled.
Fig. 6 is a perspective view showing a situation that a connection piece of the shielding cover of the antenna apparatus shown in Fig.5 and a conductive pattern of a circuit board.
Fig. 7 is a schematic cross-section view of a conventional antenna apparatus which a tongue is provided in a shielding cover.
Fig. 8 is a perspective view of the antenna apparatus shown in Fig. 7.

### DETAILED DESCRIPTION OF EXEMPLIFIED EMBODIMENTS

Exemplified embodiments of the invention are described below in detail with reference to the accompanying drawings.

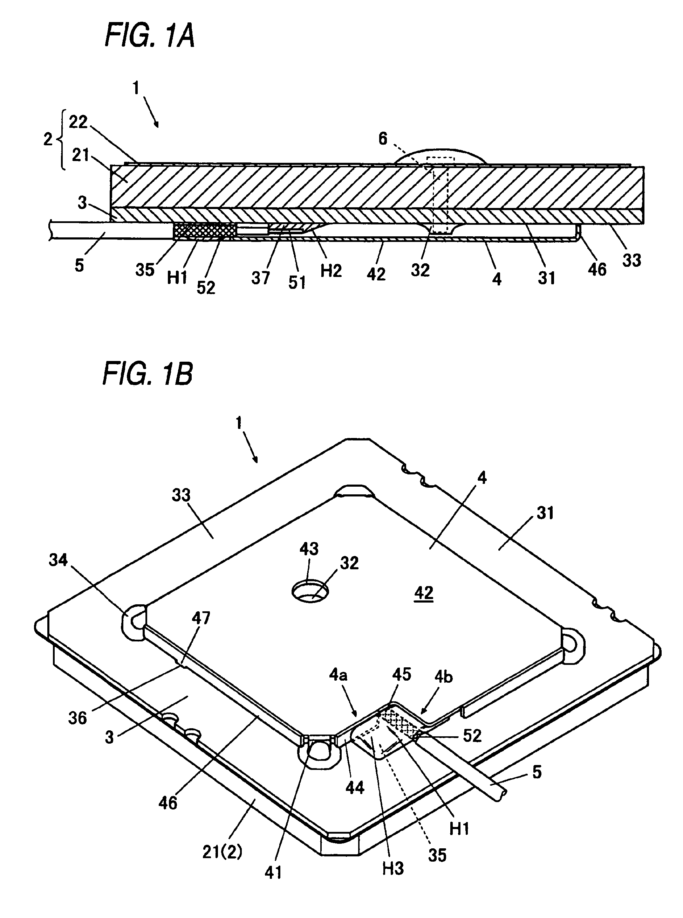

As shown in Figs. 1A and 1 B, an antenna apparatus 1 of the present embodiment has an antenna element 2, a circuit board 3, a shielding cover 4, and a coaxial cable 5. In Fig. 1A, a conductive pattern 35 of the circuit board 3 is depicted as being thicker than an actual conductive pattern. In Fig. 1 B and Figs. 4 through 6 to be described later, the antenna apparatus 1 shown in Fig. 1A is shown upside down.

In the present embodiment, the antenna element 2 is formed in such a way that a patch-type receiving surface 22 serving as receiving means for receiving a radio wave is affixed to one side of a ceramic plate 21. In Fig. 1A, the receiving surface 22 of the antenna element 2 is depicted as being thicker than an actual receiving surface. An unillustrated thin-film metal GND pattern is affixed to an substantially-entire surface, except an input pin 6 and its surroundings, on one side of the antenna element 2 to a side that the receiving surface 22 is provided.

The circuit board 3 is provided on one side of the ceramic plate 21 of the antenna element 2 opposite its other side affixed with the receiving surface 22. An unillustrated thin-film metal GND pattern differing from the GND pattern of the antenna element 2 is affixed to an substantially-entire surface, except the input pin 6 and its surroundings, of the circuit board 3 facing the antenna element 2.

In the present embodiment, the GND pattern of the circuit board 3 and the GND pattern of the antenna element 2 are affixed together by an adhesive member; for instance, a double-sided tape or the like, whereby the antenna element 2 and the circuit board 3 are bonded together. In conjunction with the GND pattern of the antenna element 2, the GND pattern of the circuit board 3 serves also as the GND pattern of the antenna element 2.

An unillustrated circuit that performs amplification of a radio wave signal input from the antenna element 2, and the like, is fabricated on a surface 31 (hereinafter called a "circuit surface 31") of the circuit board 3 opposite to a surface that the antenna element 2 is provided. The input pin 6 is vertically inserted, in a penetrating manner, at a predetermined position on the receiving surface 22 of the antenna element 2 and a predetermined position on the circuit surface 31 of the circuit board 3. One end of the input pin 6 is soldered to the receiving surface 22, and the other side of the same is soldered to an input section 32 of the circuit. The input pin 6 inputs the radio wave signal received by the receiving surface 22 of the antenna element 2 to the circuit of the circuit board 3.

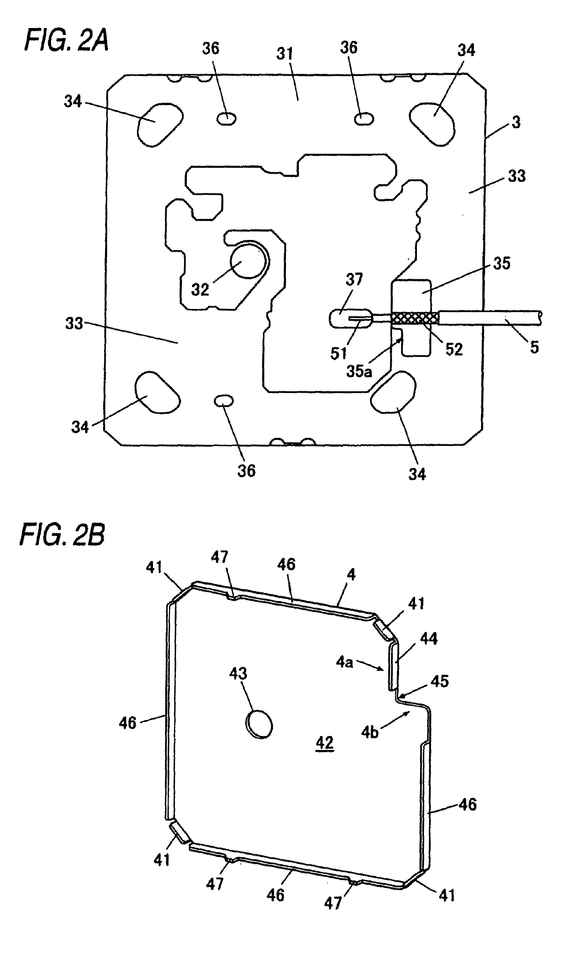

As shown in Fig. 1B and a bottom view of Fig. 2A, a GND pattern 33 is formed around an area of the circuit surface 31 of the circuit board 3 where the circuit is fabricated, and at least a portion of the GND pattern 33 located outside the shielding cover 4 is covered with a coating. Fig. 2A shows the circuit board from which the shielding cover 4 is removed. The drawing also shows that a core wire 51 and an outer conductor 52 of the coaxial cable 5 are not yet soldered to an output section 37 and the conductive pattern 35.

In areas of the circuit board 3 corresponding to side walls 41 of four corners of the shielding cover 4, the coating of the GND pattern 33 is removed, whereupon the GND pattern 33 is exposed, to thus form connection sections 34. In the connection sections 34, the GND pattern 33 and the shielding cover 4 are soldered together, whereby the shielding cover 4 is fastened to the circuit board 3. Further, the shielding cover 4 and the GND pattern 33 of the circuit board 3 are electrically connected together.

Unillustrated through holes are formed at appropriate positions on the circuit board 3, and the GND pattern 33 on the circuit surface 31 and the GND pattern provided on the back of the circuit board are connected together by way of the through holes.

The conductive pattern 35 to which the outer conductor 52 of the coaxial cable 5 is soldered by the solder H1 is formed on the GND pattern 33 of the circuit surface 31 of the circuit board 3. The conductive pattern 35 is formed by removing the coating of the GND pattern 33 or placing a thin metal film, by affixation or plating, on the area of the GND pattern 33 where the conductive pattern 35 is to be formed. The conductive pattern 35 is electrically connected to the GND pattern 33. The conductive pattern 35 is described in detail later.

As shown in Fig. 1A, the substantially-box-shaped metal shielding cover 4 is attached to the circuit surface 31 of the circuit board 3, so as to cover the circuit on the circuit surface 31. The shielding cover 4 blocks a disturbing wave arriving at the circuit from the outside. A base surface 42 of the shielding cover 4 is positioned in parallel to the receiving surface 22 of the antenna element 2 and the circuit surface 31 of the circuit board 3.

As shown in Figs. 1 B and 2B, a hole 43 is opened at a position on the base surface 42 of the shielding cover 4 facing the input section 32. It is possible to ascertain whether or not the input section 32 is soldered or whether or not a soldering failure is present in the input section 32, by visually checking a soldered area between the input pin 6 in the input section 32 and the input section 32 of the circuit by way of the hole 43.

In the present embodiment, the shielding cover 4 assumes a shape defined by removing a substantially rectangular part from one corner of the substantially-rectangular base surface 42, thereby defining a recessed part. Of two edges 4a and 4b in the cut area that intersect substantially at right angles, a portion of the edge 4a is extended toward the circuit board 3, and the thus-extended portion is provided with a connection piece 44. The other portion of the edge 4a forms an opening 45 into which the coaxial cable 5 is inserted.

To be more precise, the connection piece 44 is formed so as to extend toward the circuit board 3 from an area of the edge 4a in the recessed part of the base surface 42 of the shielding cover 4, the area being spaced apart from the other edge 4b. The opening 45 is formed in the remaining area of the edge 4a; namely, the area of the edge 4a closer to the edge 4b than to the connection piece 44.

As is described later, the connection piece 44 of the shielding cover 4 is soldered to the conductive pattern 35 by a solder H3, whereby the shielding cover 4 and the outer conductor 52 of the coaxial cable 5 are electrically connected together by way of the conductive pattern 35. In conjunction with other side walls 46 of the shielding cover 4, the connection piece 44 doubles also as a side wall of the shielding cover 4 and exhibits a function of blocking a disturbing wave reaching the circuit from the outside.

As shown in Fig. 1 B, when the shielding cover 4 is attached to the circuit board 3, the conductive pattern 35 of the circuit board 3 is provided so as to be located outside the connection piece 44 of the shielding cover 4 on the circuit surface 31 of the circuit board 3.

A projection 47 used for positioning the shielding cover 4 when the shielding cover 4 is attached to the circuit board 3 is provided on the side wall 46 of the shielding cover 4. In the present embodiment, two projections 47 are provided on one side wall 46 of the shielding cover 4, and one projection 47 is provided on the side wall 46 opposing that side wall 46 having two projections 47. The two projections 47 and the one projection 47 are inserted into two mount holes 36 and one mount hole 36 opened at corresponding positions on the circuit board 3, whereby the shielding cover 4 is positioned with respect to the circuit board 3.

The coaxial cable 5 is inserted to the inside of the shielding cover 4. The core wire 51 of the coaxial cable 5 is fastened and electrically connected to the output section 37 of the circuit on the circuit board 3 by soldering through use of the solder H2. Power is supplied to the circuit by way of the core wire 51, and a signal amplified by the circuit is output there through.

The outer conductor 52 of the coaxial cable 5 is fastened and electrically connected to the conductive pattern 35 of the circuit board 3 by soldering through use of the solder H1. A GND potential is supplied to the GND pattern 33 of the circuit board 3 and the shielding cover 4 by way of the electrical connection between the outer conductor 52 and the conductive pattern 35.

More detailed configurations, and others, of the antenna apparatus 1 will now be described by reference to procedures for manufacturing the antenna apparatus 1 of the present embodiment, and advantageous effects of the configuration will also be described.

Wiring of the circuit and the GND pattern 33 are laid on the circuit surface 31 of the circuit board 3. The connection sections 34, the conductive pattern 35, and others, are formed. The circuit board 3 on which electronic components are mounted is affixed to the antenna element 2 by an adhesive member, and the input pin 6 is inserted into the circuit board. One end of the input pin is connected to the receiving surface 22 of the antenna element 2 by soldering, and the other end of the same is connected to the input section 32 of the circuit of the circuit board 3 by soldering.

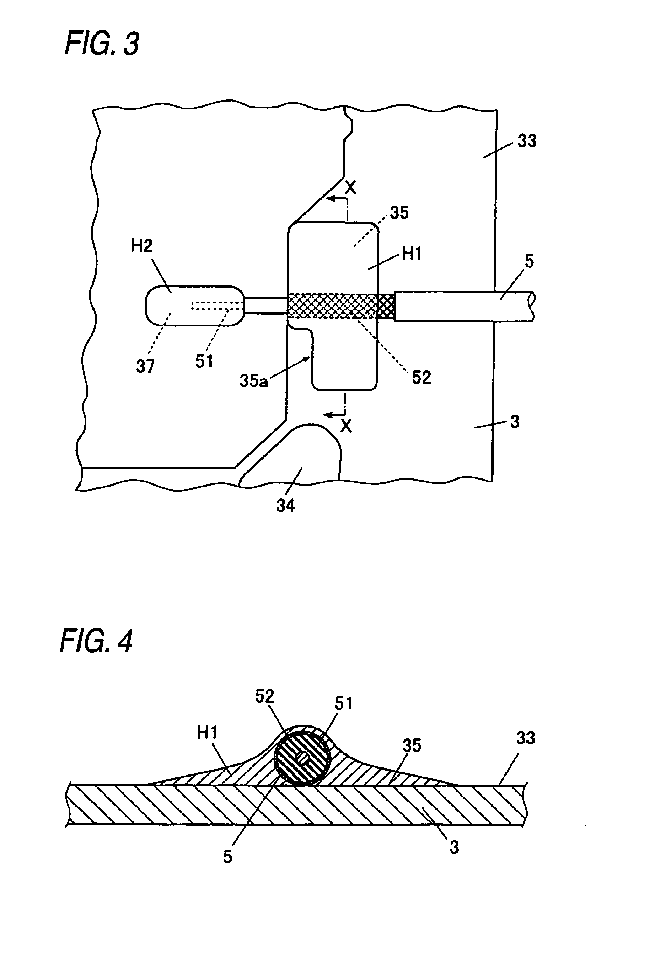

As shown in Fig. 2A, the coaxial cable 5 is arranged in such a way that the core wire 51 comes to the location of the output section 37 of the circuit and that the outer conductor 52 comes to the location of the conductive pattern 35 of the circuit board 3. As shown in Fig. 3, the outer conductor 52 of the coaxial cable 5 is soldered to the conductive pattern 35 by the solder H1, and the core wire 51 is soldered to the output section 37 of the circuit by the solder H2.

As shown in a cross-section view of Fig. 4, it is preferable to solder the conductive pattern 35 to the outer conductor 52 of the coaxial cable 5 by infiltrating the solder H1 to the entire peripheral area of the outer conductor 52 of the coaxial cable 5. By the soldering operation, an area of contact between the conductive pattern 35 and the outer conductor 52 is increased, whereby grounding efficiency of the GND pattern 33 of the circuit board 3 is enhanced. Further, as is described later, grounding efficiency of the shielding cover 4 connected to the outer conductor 52 by way of the conductive pattern 35 is also enhanced. An illustration of the antenna element 2, and the like, is omitted from Fig. 4.

Subsequently, the shielding cover 4 is attached to the circuit board 3 to which the coaxial cable 5 is connected as mentioned above while the projections 47 (see Fig. 2B) of the shielding cover 4 are inserted into and positioned at the mount holes 36 of the circuit board 3. The four corner side walls 41 of the shielding cover 4 are soldered to the connection sections 34 formed as a result of uncovering of the GND pattern 33 of the circuit board 3, whereby the shielding cover 4 is fixed to the circuit board 3. Further, the shielding cover 4 and the GND pattern 33 of the circuit board 3 are electrically connected together.

At that time, there would be a case where the solder H1 is somewhat raised outwardly on the surface of the conductive pattern 35, as shown in Fig. 4. If the shielding cover 4 is attached to the circuit board from above, the connection piece 44 of the shielding cover 4 would contact the solder H1 solidified in a raised manner, thereby causing a leading edge of the side wall 46 of the shielding cover 4 to upwardly come off the circuit board 3.

If the shielding cover 4 upwardly comes off the circuit board 3, parallelism between the base surface 42 of the shielding cover 4 and the circuit surface 31 of the circuit board 3 is lost, and the corner side walls 41 of the shielding cover 4 are less likely to be soldered to the connection sections 34 of the circuit board, thereby hindering electrical connection between the shielding cover 4 and the GND pattern 33 of the circuit board 3 and causing a connection failure.

Therefore, as shown in Figs. 2A and 3, the conductive pattern 35 is arranged in such a way that an edge 35a of the conductive pattern 35 opposing the connection piece 44 escapes from the connection piece 44 when the shielding cover 4 is attached to the circuit board 3; namely, such that the connection-piece-side edge 35a is positioned, on the circuit board 3, outside a point of contact between the connection piece 44 and the circuit board 3 or a point of intersection of an extension of the connection piece 44 and the circuit board 3 when the connection piece 44 does not contact the circuit board 3.

By such a configuration, even when the solder H1 becomes solidified while remaining raised on the conductive pattern 35, the connection piece 44 of the shielding cover 4 does not contact the solder H1 when the shielding cover 4 is attached to the circuit board 3. Therefore, the shielding cover 4 is prevented from upwardly coming off the circuit board 3 and can be attached to the circuit board while parallelism between the base surface 42 of the shielding cover 4 and the circuit surface 31 of the circuit board 3 is assured. Further, electrical connection between the shielding cover 4 and the GND pattern 33 of the circuit board 3 can be assured by way of the connection section 34.

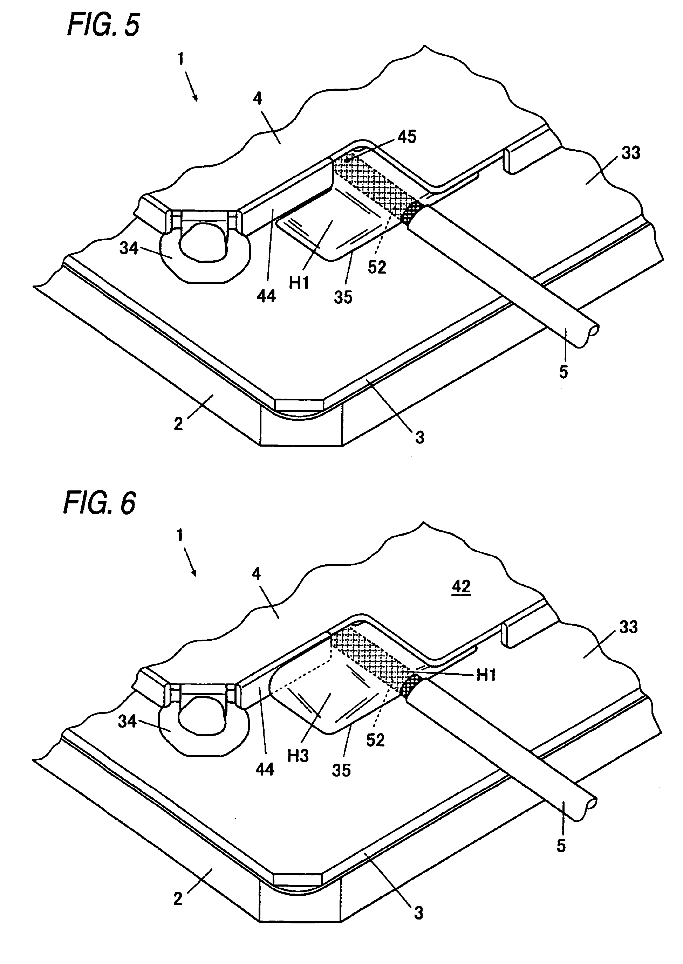

A positional relationship between the outer conductor 52 of the coaxial cable 5, the conductive pattern 35 of the circuit board 3, and the connection piece 44 of the shielding cover 4 is achieved in this stage as shown in Fig. 5. Specifically, the coaxial cable 5 whose outer conductor 52 is connected to the conductive pattern 35 of the circuit board 3 by the solder H1 is inserted to the inside of the shielding cover 4 by way of the opening 45 located beside the connection piece 44.

Subsequently, as shown in Fig. 6, the connection piece 44 of the shielding cover 4 and the conductive pattern 35 of the circuit board 3 are soldered together by the solder H3 at a position next to the coaxial cable 5, in an axial direction thereof, on the conductive pattern 35 to which the outer conductor 52 of the coaxial cable 5 is soldered. At that time, the solder H1 and the solder H3 are fused with each other.

As mentioned above, the conductive pattern 35 and the connection piece 44 of the shielding cover 4 are soldered beside the coaxial cable 5 in its axial direction. As a result, it becomes possible to perform soldering operation through use of the solder H3 by causing a soldering iron to approach an area of the conductive pattern 35 close to the connection piece 44 from a side where the base surface 42 of the shielding cover 4 is not present and where an open space is present. Even when the shielding cover 5 is reduced in size and height, soldering of the solder H3 can be performed sufficiently easily and reliably.

The connection piece 44 of the shielding cover 4 and the conductive pattern 35 are soldered together by the solder H3 while the outer conductor 52 of the coaxial cable 5 is soldered to the conductive pattern 35 of the circuit board 3 by the solder H1, whereby the shielding cover 4 is electrically connected to the outer conductor 52 of the coaxial cable 5 by way of the conductive pattern 35.

Even if the solder H3 and the solder H1 that is fused concurrently with the solder H3 are infiltrated into the space between the connection piece 44 and the circuit board 3 at the time of soldering of the connection piece 44 of the shielding cover 4 to the conductive pattern 35 of the circuit board 3, the connection piece 44 of the shielding cover 4 does not upwardly come off because the shielding cover 4 is already connected and fastened to the circuit board 3. Hence, loss of parallelism between the base surface 42 of the shielding cover 4 and the circuit surface 31 of the circuit board 3 does not arise.

The antenna apparatus 1 of the present embodiment is manufactured in such a manner. When a GND potential is fed from the outer conductor 52 of the coaxial cable 5, the GND potential is fed to the GND pattern 33 of the circuit board 3 by way of the solder H1 and the conductive pattern 35, whereupon the circuit is grounded. Further, the GND potential is also fed to the shielding cover 4 from the outer conductor 52 of the coaxial cable 5 by way of the solder H1 and H3, the conductive pattern 35, and the connection piece 44, whereupon the shielding cover is grounded.

Since the corner side walls 41 of the shielding cover 4 and the connection sections 34 of the GND pattern 33 of the circuit are electrically connected to each other by soldering, the shielding cover and the GND pattern are mutually enhanced in terms of grounding efficiency, and the efficiency of blocking a disturbing wave from the outside of the shielding cover 4 is also enhanced.

As mentioned above, in the antenna apparatus 1 of the present embodiment, when a GND potential is fed to the conductive pattern 35 from the outer conductor 52 of the coaxial cable 5, the GND pattern 33 of the circuit board 3 is grounded, and the shielding cover 4 is also supplied with the GND potential by way of the connection piece 44, and the like, and hereby grounded.

The shielding cover 4 is provided with a structure in which the outer conductor 52 of the coaxial cable 5 and the connection piece 44 of the shielding cover 4 are connected to the conductive pattern 35 provided on the circuit board 3 by soldering rather than the structure in which the tongue 104b, such as that provided in the antenna apparatus 100 described in connection with Patent Document 2, is provided. Therefore, the thickness of the shielding cover 4; namely, the distance between the base surface 42 and the circuit surface 31 of the circuit board 3, can be reduced to about an outer diameter of the coaxial cable 5 inserted into the shielding cover or an outer diameter of the outer conductor 52 of the coaxial cable.

Using a cable having a small diameter as the coaxial cable 5 to be inserted enables making of an attempt to reduce the size and height of the shielding cover 4 to about the outer diameter of the coaxial cable 5 having a reduced diameter, whereby an attempt can be made to reduce the size and height of the entire antenna apparatus 1. Therefore, the antenna apparatus 1 can be sufficiently downsized to the extent that the antenna apparatus 1 can be incorporated in the above described PND, and the like.

Further, the coaxial cable 5 is fastened to the circuit board 3 by soldering the outer conductor 52 of the coaxial cable 5 to the conductive pattern 35 provided on the circuit board 3. Hence, there is obviated a necessity for a special coaxial cable connection structure, such as that required in the antenna apparatus described in connection with Patent Document 1; operation for connecting the coaxial cable 5 to the circuit board 3 is facilitated; and a connection can be established reliably.

Moreover, the shielding cover 4 is attached to the circuit board 3 after the core wire 51 of the coaxial cable 5 is connected to the input section 32 of the circuit by soldering. Hence, there is obviated a necessity of forming in the shielding cover a large opening for soldering the core wire of the coaxial cable to the input section as in the antenna apparatus described in connection with Patent Document 1, so that deterioration in the performance of the shielding cover for blocking a disturbing wave can be prevented.

The antenna apparatus 1 of the present embodiment is described in connection with the case where the hole 43 for visually ascertaining the soldered portion of the input section 32 of the circuit is opened in the base surface 42 of the shielding cover 4. However, needless to say, the hole 43 is formed to a size that does not incur deterioration in the performance of the shielding cover 4 for blocking disturbing waves.

The shape of the shielding cover 4 may be polygonal, circular or any other shape which is able to cover the circuit.

## Claims

1. An antenna apparatus, comprising:
an antenna element;
a board;
a circuit, provided on the board and configured to amplify a signal received by the antenna element;
a conductive pattern, provided on the board;
a coaxial cable comprising a core wire connected to the circuit and an outer conductor;
a shielding cover disposed on the board and covering the circuit; and
a solder electrically connecting the outer conductor with the conductive pattern and electrically connecting a part of the shielding cover with the conductive pattern.

2. The antenna apparatus set forth in Claim 1, wherein:
the conductive pattern is electrically grounded.

3. The antenna apparatus set forth in Claim 1, wherein:
the part of the shielding cover serves as a side wall of the shielding cover.

4. The antenna apparatus set forth in Claim 1, wherein:
the part of the shielding cover is adjacent to the coaxial cable in a direction which is parallel to the board.

5. The antenna apparatus set forth in Claim 1,
wherein the shielding cover is formed with an opening through which the coaxial cable is inserted into inside of the shielding cover, and
wherein the part of the shielding cover defines a part of the opening.

6. The antenna apparatus set forth in Claim 5,
wherein at least a part of the conductive pattern is disposed outside of the shielding cover,
wherein the shielding cover comprises a plate having a first edge and a second edge intersecting the first edge, and
wherein the first edge and the second edge face the part of the conductive pattern,
wherein the part of the shielding cover is extended from the first edge towards the board.

7. The antenna apparatus set forth in Claim 6, wherein:
the opening is disposed between the second edge and the part of the shielding cover.

8. The antenna apparatus set forth in Claim 1, wherein:
at least a part of the conductive pattern is disposed outside of the shielding cover.

9. The antenna apparatus set forth in Claim 8, wherein:
an edge of the part of the conductive pattern opposes the part of the shielding cover with a gap in a direction which is parallel to the board.
